# EUROPEAN PATENT APPLICATION

(11) **EP 4 707 056 A1**
(43) Date of publication of application: **11.03.2026**
(21) Application number: 24883629.8
(22) Date of filing: 27.11.2024
(51) Int. Cl.: B60L 53/302, H02B 1/56

(54) **ENERGY STORAGE DEVICE**

(30) Priority: 08.07.2024 CN 202421595286 U
(71) Applicant: Contemporary Amperex Technology Co., Limited, Jiaocheng District Ningde Fujian 352100 (CN); Contemporary Amperex Future Energy Technology (Shenzhen) Limited, Shenzhen, Guangdong 518100 (CN)
(72) Inventor: XU, Jinmei, Ningde, Fujian 352100 (CN); ZHENG, Zhimin, Ningde, Fujian 352100 (CN); WANG, Lei, Ningde, Fujian 352100 (CN); CHENG, Yong, Ningde, Fujian 352100 (CN)
(74) Representative: Gong, Jinping
(86) International application number: PCT/CN2024/135005
(87) International publication number: WO 2026/011657

(57) **Abstract**

Embodiments of the present disclosure provide an energy storage apparatus, the energy storage apparatus including a cabinet body, an energy storage component, a charging gun and a cable, wherein air vents and a cable outlet are arranged on an outer surface of the cabinet body, the air vents include air inlets, and the air inlets are used for airflow entering the cabinet body; the energy storage component is arranged in the cabinet body; the charging gun is configured to be separable from the outer surface of the cabinet body; and a portion of the cable is positioned outside the cabinet body, one end of the cable is electrically connected to the charging gun, the other end enters the cabinet body through the cable outlet and is electrically connected to the energy storage component, and at least a portion of the cable passes through the air inlets.

## Description

### CROSS-REFERENCE TO RELATED APPLICATIONS

The present disclosure is based on Chinese Patent Application No. 202421595286.8 filed on July 8, 2024 and entitled "ENERGY STORAGE APPARATUS", and claims the priority of the China patent application, the entire content of which is hereby incorporated into the present disclosure as a reference.

### TECHNICAL FIELD

Embodiments of the present disclosure relate to the technical field of energy storage, and specifically relate to an energy storage apparatus.

### BACKGROUND

In recent years, the new energy industry has developed vigorously. Electricity storage has become an important form of energy storage in a new energy system.

An energy storage apparatus refers to an apparatus that can be used to store and release electric energy, and can store surplus electric energy in a power grid and release the stored electric energy as required, which helps alleviate the contradiction between power supply and power consumption in the power grid and alleviate the problem of power fluctuation of the power grid caused by uneven distribution of power consumption time.

Some types of energy storage apparatuses are provided with a charging gun, and the charging gun is used to output electric energy to an electrical apparatus, e.g., an electric vehicle, for charging.

The charging gun is electrically connected to an energy storage component of the energy storage apparatus through a cable, so that the energy storage component provides electric energy to the charging gun through the cable. When the charging gun outputs electric energy, the cable generates heat due to resistance, which has an adverse effect on the charging efficiency of the charging gun.

### SUMMARY OF THE INVENTION

In view of this, embodiments of the present disclosure are intended to provide an energy storage apparatus that helps dissipate heat from a cable connected to a charging gun.

To achieve the objective, the technical solutions in the embodiments of the present disclosure are implemented as follows:
the embodiments of the present disclosure provide an energy storage apparatus, the energy storage apparatus including:
a cabinet body, wherein air vents and a cable outlet are arranged on an outer surface of the cabinet body, the air vents include air inlets, and the air inlets are used for airflow entering the cabinet body;
an energy storage component, being arranged in the cabinet body;
a charging gun, being configured to be separable from the outer surface of the cabinet body; and
a cable, a portion of the cable being positioned outside the cabinet body, one end of the cable being electrically connected to the charging gun, the other end entering the cabinet body through the cable outlet and being electrically connected to the energy storage component, and at least a portion of the cable passing through the air inlets.

According to the energy storage apparatus in the embodiments of the present disclosure, at least a portion of the cable passes through the air inlets so that the cable can directly dissipate heat and cool through the airflow entering through the air inlets, thereby reducing the adverse effect of high temperature of the cable on the charging efficiency of the charging gun. The airflow for heat exchange with the cable is the normal temperature airflow from the outside, which helps increase the temperature difference between the airflow and the cable, improve the efficiency of heat exchange, and improve the cooling effect on the cable. The air vents are formed on the surface of the cabinet body, which helps reduce the overall outer contour size of the energy storage apparatus and improve the mounting adaptability of the energy storage apparatus.

In some embodiments, the air vents further include air outlets, the air outlets are used to discharge the airflow in the cabinet body out of the cabinet body, the air inlets are arranged on a first wall of the cabinet body, and the air outlets are arranged on a second wall of the cabinet body.

Thus, the air discharged from the air outlets is not likely to re-enter through the air inlets without completely cooling, which helps reduce the probability of temperature rise of the airflow entering through the air inlets, increase the temperature difference between the airflow and the cable, improve the efficiency of heat exchange, and improve the cooling effect on the cable.

In some embodiments, a placing area for placing the charging gun is arranged on the outer surface of the cabinet body, and the cable outlet, the placing area and the air outlets are all positioned on the first wall.

Thus, the probability that the cable passes by the second wall is reduced during use of the charging gun, which helps reduce the probability that the airflow discharged from the air outlets blows onto the cable.

In some embodiments, the air vents and the cable outlet are positioned on the same wall of the cabinet body, and at least one air vent is arranged around the cable outlet;
or, a plurality of air vents are arranged at intervals on the circumferential side of the cable outlet.

Thus, the portion of the cable positioned near the cable outlet can always exchange heat with the airflow entering and exiting through the air vents, thereby improving the heat dissipation effect on the cable.

In some embodiments, the energy storage apparatus further includes a limiting member. The limiting member is arranged on the outer surface of the cabinet body, the limiting member is provided with a support surface, and the support surface supports the cable in a vertical direction. In a state where the charging gun is placed on the cabinet body, the support surface is not lower than at least one of the connection position between the charging gun and the cable and the cable outlet in the vertical direction.

Thus, the cable is supported by the support surface, which helps increase the length of the portion of the cable outside the cabinet body. Also, since the limiting member can limit the cable through friction, the portion of the cable between the support surface and the cable outlet can maintain stable in position when the charging gun is moved, which helps maintain heat exchange between the airflow at the air vents and the portion of the cable, and improve the cooling efficiency.

In some embodiments, the air vents and the limiting member are positioned on the same wall of the cabinet body, and at least one air vent is arranged around the limiting member;
or, a plurality of air vents are arranged at intervals on the circumferential side of the limiting member.

Thus, the portion of the cable positioned near the limiting member can always exchange heat with the airflow entering and exiting through the air vents, thereby improving the heat dissipation effect on the cable.

In some embodiments, a placing area for placing the charging gun is arranged on the outer surface of the cabinet body, the air vents include air inlets and air outlets, the limiting member, the cable outlet, the placing area and the air outlets are all positioned on the first wall of the cabinet body, and the air outlets are positioned on the second wall of the cabinet body.

Thus, the probability that the cable passes by the second wall is reduced during use of the charging gun, which helps reduce the probability that the airflow discharged from the air outlets blows onto the cable.

In some embodiments, on a projection plane perpendicular to the vertical direction, the projection of the limiting member along the vertical direction is between the projection of the cable outlet along the vertical direction and the projection of the placing area along the vertical direction.

Thus, the probability that the portion of the cable from the end connected to the charging gun to the limiting member is in overlapping contact with the portion of the cable from the limiting member to a cable through hole under the action of gravity is reduced, which helps make the two portions hang naturally under gravity, reduce the probability that the portion of the cable from the limiting member to the cable through hole moves away from the air vents, and improve the heat dissipation effect.

In some embodiments, in the vertical direction, the distance between the support surface and the bottom surface of the cabinet body is 2 m or more. Thus, the probability that the cable on the support surface moves or even falls off the support surface due to the movement of the charging gun is reduced, and also the portion of the cable from the limiting member to the cable through hole is maintained stable in position and passing through the air vents.

In some embodiments, a cable through hole is formed in the limiting member, the cable passes through the cable through hole, and the bottom wall of the cable through hole forms the support surface. Thus, on the one hand, the inside of the cable through hole can support the cable, and on the other hand, the side wall of the cable through hole can restrain the cable in a direction perpendicular to the vertical direction, which further helps restrain the movement range of the cable and reduce the probability that the cable escapes from the influence range of the airflow at the air vents.

In some embodiments, the cross-sectional area of the cable through hole perpendicular to the extension direction thereof is larger than the cross-sectional area of the cable perpendicular to the extension direction thereof. Thus, the length of the cable from the charging gun to the limiting member can be flexibly adjusted according to the charging position requirement of an electrical apparatus for the charging gun, and the flexibility in use is improved.

In some embodiments, the energy storage apparatus further includes a heat dissipation device, and the heat dissipation device is arranged in the cabinet body and is used to dissipate heat from the energy storage component and drive airflow in and out through the air vents. Thus, the airflow formed by the heat dissipation device is directly used to dissipate heat from the cable, which helps simplify the structure of the energy storage apparatus and reduce the power consumption of the energy storage apparatus.

In some embodiments, the heat dissipation device is positioned above the energy storage component, and the air vents are positioned on at least one side of the heat dissipation device perpendicular to the vertical direction.

Thus, the height of center of gravity of the energy storage apparatus is lowered and the risk of the energy storage apparatus overturning is reduced. The projections of the heat dissipation device and the energy storage component in the vertical direction at least partially overlap, and the footprint of the energy storage apparatus is reduced. The length of the airflow path from the air vents to the heat dissipation device is reduced and the airflow efficiency is improved. The position of the air vents is relatively high, which helps reduce the probability that the airflow at the air vents blows onto an operator during the charging operation on the energy storage apparatus.

### BRIEF DESCRIPTION OF DRAWINGS

FIG. 1 is a front view of an energy storage apparatus in a first embodiment of the present disclosure;
FIG. 2 is a right side view of the embodiment shown in FIG. 1;
FIG. 3 is a rear view of the embodiment shown in FIG. 1;
FIG. 4 is a partially enlarged schematic diagram of a position A in FIG. 2;
FIG. 5 is a partially enlarged schematic diagram of an energy storage apparatus in a second embodiment of the present disclosure, wherein the enlarged position is the same as the position A in FIG. 2;
FIG. 6 is a partially enlarged schematic diagram of a position B in FIG. 2;
FIG. 7 is a partially enlarged schematic diagram of an energy storage apparatus in the second embodiment of the present disclosure, wherein the enlarged position is the same as the position B in FIG. 2;
FIG. 8 is a partially enlarged schematic diagram of an energy storage apparatus in a third embodiment of the present disclosure, wherein the enlarged position is the same as the position B in FIG. 2, and the limiting member is illustrated partially sectioned;
FIG. 9 is a partially enlarged schematic diagram of a position C in FIG. 3;
FIG. 10 is a partially enlarged schematic diagram of an energy storage apparatus in the third embodiment of the present disclosure, wherein the enlarged position is the same as the position C in FIG. 3; and
FIG. 11 is a cross-sectional schematic diagram of a position D-D in FIG. 1.

### Description of reference numerals

10. Cabinet body; 10a. Air vent; 10b. Cable outlet; 10c. Air inlet; 10d. Air outlet; 10e. First wall; 10f. Second wall; 10g. Placing area; 10h. Third wall; 20. Charging gun; 30. Cable; 40. Limiting member; 40a. Cable through hole; 40b. Support surface; 50. Heat dissipation device; 60. Energy storage component.

### DETAILED DESCRIPTION OF THE INVENTION

It should be noted that, without conflict, the embodiments and technical features in the present disclosure can be combined with each other. The detailed description in the specific embodiments should be understood as an explanation of the purpose of the present disclosure and should not be regarded as an inappropriate limitation on the present disclosure.

Unless otherwise defined, all technical and scientific terms used herein have the same meanings as commonly understood by those skilled in the art in the present disclosure. The terms used herein are intended only for the purpose of describing specific embodiments and are not intended to limit the present disclosure. The terms "include" and "have" and any variants thereof in the specification of the present disclosure and the description of drawings above are intended to cover non-exclusive inclusion.

In the description of the embodiments of the present disclosure, the technical terms "first", "second", "third", and the like are used only to distinguish between different objects, and are not to be understood as indicating or implying a relative importance or implicitly specifying the number, particular order, or primary and secondary relation of the technical features indicated. In the description of the embodiments of the present disclosure, "a plurality of" means two or more, unless otherwise explicitly and specifically defined.

The reference to "embodiment" herein means that specific features, structures or characteristics described in combination with the embodiment may be included in at least one embodiment of the present disclosure. The word appearing in various parts of the specification does not necessarily refer to the same embodiment, nor is it an independent or alternative embodiment mutually exclusive of other embodiments. It is explicitly and implicitly understood by those skilled in the art that the embodiments described herein may be combined with other embodiments.

In the description of the embodiments of the present disclosure, the term "and/or" is only an association relationship for describing associated objects, indicating that three relationships may exist. For example, A and/or B may indicate three situations: A exists alone, both A and B exist, and B exists alone. In addition, the character "/" herein generally means that the associated objects before and after it are in an "or" relationship.

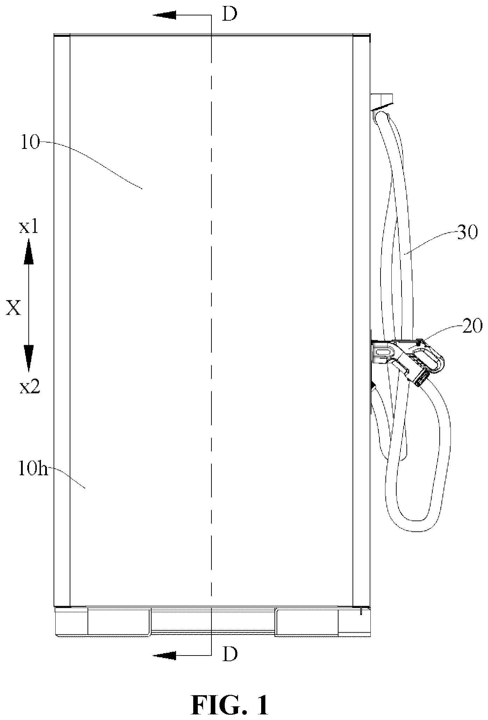

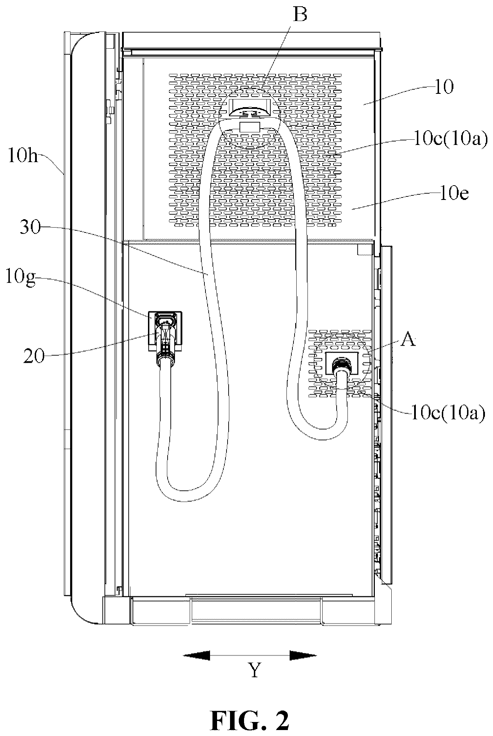

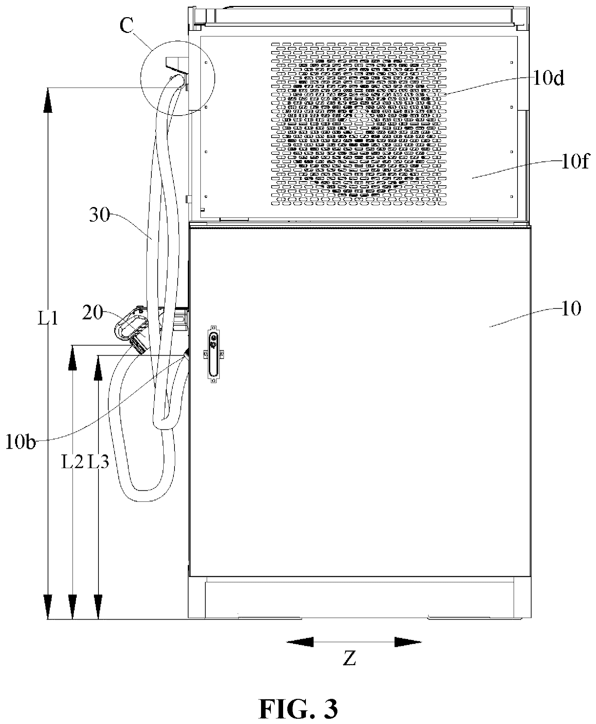

In the description of the embodiments of the present disclosure, for ease of explanation, as shown in FIG. 1, the direction indicated by the arrow X is taken as the rectilinear direction of the "vertical direction", the pointing direction of x1 represents "up" and "top", and the pointing direction of x2 represents "down", "bottom" and "gravity direction"; as shown in FIG. 2, the direction indicated by the arrow Y is taken as a "second direction"; and as shown in FIG. 3, the direction indicated by the arrow Z is taken as a "first direction".

In the description of the embodiments of the present disclosure, unless otherwise explicitly specified and defined, the technical terms such as "mount", "connect", "link" and "fix" should be understood in a broad sense. For example, the connection may be fixed connection, detachable connection or integrated connection, may be mechanical connection or electrical connection, or may be direct connection, indirect connection through an intermediate, internal communication between two elements or interaction relationship between two elements. For those of ordinary skill in the art, the specific meanings of the above terms in the embodiments of the present disclosure can be understood according to specific situations.

In the description of the embodiments of the present disclosure, unless otherwise explicitly specified and defined, the technical term "contact" should be understood in a broad sense, which may be direct contact, or contact through an intermediate layer, or contact between two objects that have substantially no interaction force, or contact between two objects that have interaction force.

The embodiments of the present disclosure provide an energy storage apparatus, which includes one or more energy storage components to increase the voltage and capacity of the energy storage apparatus. The energy storage component may include a plurality of battery apparatuses, and the plurality of battery apparatuses are connected in series through a busbar component to increase the voltage of the energy storage apparatus. In a case that the energy storage apparatus includes a plurality of energy storage components, the plurality of energy storage components are connected in parallel to increase the capacity of the energy storage apparatus.

The energy storage apparatus may be used in energy storage power stations, wind power generation systems, solar power generation systems, mobile power systems, temporary power supply systems, or the like. The energy storage apparatus may store electric energy as needed and output the electric energy at the appropriate time. For example, the energy storage apparatus may store electric energy at the valley time of electricity consumption and provide electric energy to relevant users or electrical devices at the peak time of electricity consumption. An energy storage system provided by the embodiments of the present disclosure may be any power system that requires an energy storage apparatus.

In some embodiments, the energy storage apparatus is an energy storage container or an energy storage cabinet.

In some embodiments, the energy storage apparatus may include a cabinet body and one or more energy storage components, and the energy storage components are accommodated in the cabinet body.

In some embodiments, the energy storage apparatus may include a thermal management module, a main control module, a master control module, a power distribution module, a fire protection module, and the like.

As an example, the thermal management module may include a liquid cooling unit, and the liquid cooling unit provides cooling liquid for regulating the temperature of a battery cell to each battery apparatus through a pipeline.

As an example, the main control module may be used as a battery management unit of the energy storage component to monitor and manage the energy storage component. The main control module may monitor the current, voltage, power, temperature, or the like of the energy storage component, e.g., control the charging and discharging current, voltage, and the like of the energy storage component. The main control module includes a slave battery management unit (SBMU), a fusion switch, and the like.

As an example, the master control module may be used as a battery management unit of the energy storage apparatus to monitor and manage the energy storage apparatus. The master control module may monitor the current, voltage, power, state of charge, temperature, or the like of the energy storage apparatus. e.g., control the charging and discharging current, voltage, and the like of the energy storage apparatus. As an example, the master control module includes an insulation monitoring module (IMM), a master battery management unit (MBMU), EtherNet (ETH), a fiber optic conversion module, and the like.

As an example, the fire protection system includes a control panel, a detector, an alarm apparatus, and the like, which are used to detect, alarm or extinguish fire in the energy storage system.

As an example, the power distribution module may be used to distribute power to power consumption modules in the energy storage apparatus.

The battery apparatus mentioned in the embodiments of the present disclosure may include one or more battery cell assemblies for providing voltage and capacity. The battery cell assembly may include a plurality of battery cells, and the plurality of battery cells are in series, parallel, or series-parallel connection through a busbar component.

In some embodiments, the battery cell assembly is typically formed by arranging a plurality of battery cells.

As an example, the battery cell assembly may be a battery module, and the battery module includes a plurality of battery cells arranged and fixed to form an independent module. As an example, the battery module may be formed by bundling a plurality of battery cells by cable ties.

In some embodiments, the battery apparatus may be a battery pack, the battery pack includes a box body and one or more battery cell assemblies, and the battery cell assemblies are accommodated in the box body.

As an example, the battery cell assembly may be a battery module, and the battery cell assembly may be accommodated in the box body by fixing the battery module in the box body.

As an example, the battery cell assembly may also be accommodated in the box body by directly fixing a plurality of battery cells in the box body.

As an example, the box body may include a first box body and a second box body. The first box body and the second box body are buckled together to form an enclosed space in the box body to accommodate the battery cell assembly. The "enclosed" here means covered or closed, which may be sealed or unsealed. The first box body may be a top cover or a bottom plate.

As an example, the box body may include a top cover, a frame, and a bottom plate. The top cover and the bottom plate are respectively connected to the frame, so that an enclosed space is formed in the box to accommodate the battery cell assembly.

The embodiments of the present disclosure will be described in detail below.

In the related art, in addition to storing electric energy, an energy storage apparatus can also provide electric energy to electrical apparatuses to increase the scope of application of the energy storage apparatus.

The energy storage apparatus includes an energy storage component, a cable and a charging gun. The energy storage component is used to store and release electric energy. The cable electrically connects the energy storage component with the charging gun. The charging gun can be used to achieve electrical connection with an electrical apparatus to transfer the electric energy from the energy storage component to the electrical apparatus through the cable and the charging gun.

When the electrical apparatus is charged through the charging gun, the cable generates heat due to the resistance of the cable when the current passes through the cable, which has an adverse effect on the charging efficiency of the charging gun.

Based on the above problem, the embodiments of the present disclosure provide an energy storage apparatus. The energy storage apparatus is provided with air vents for airflow in and out, and the cable passes through the air vents so that the airflow can exchange heat with the cable to cool the cable.

Specifically, referring to FIG. 1 to FIG. 3, the energy storage apparatus includes a cabinet body 10, a charging gun 20 and a cable 30.

Air vents 10a and a cable outlet 10b are arranged on an outer surface of the cabinet body 10, the air vents 10a include air inlets 10c, and the air inlets 10c are used for airflow entering the cabinet body 10.

The energy storage component 60 is arranged in the cabinet body 10.

The charging gun 20 is configured to be separable from the outer surface of the cabinet body 10.

A portion of the cable 30 is positioned outside the cabinet body 10, one end of the cable is electrically connected to the charging gun 20, the other end enters the cabinet body 10 through the cable outlet 10b, and at least a portion of the cable 30 passes through the air inlets 10c.

The cabinet body 10 is used to form the outer contour surface of the energy storage apparatus, provide a mounting position for other devices in the energy storage apparatus, such as the heat dissipation device 50 and the energy storage component 60, and play a certain protective role.

Air vents 10a are formed on the surface of the cabinet body 10, and the air vents 10a are used for external airflow to enter or be discharged from the cabinet body 10 through the air vents 10a, so as to directly or indirectly achieve heat exchange with the devices in the cabinet body 10, such as the energy storage component 60, through the airflow, thereby dissipating heat.

The specific type of the energy storage component 60 is not limited, and includes, for example, a battery, a supercapacitor and a flywheel energy storage device.

The charging gun 20 is used to electrically connect an electrical apparatus to charge the electrical apparatus.

The charging gun 20 being configured to be separable from the cabinet body 10 means that the charging gun 20 can be placed on the cabinet body 10 to fix the position of the charging gun 20, and can also be separated from the cabinet body 10 so that the charging gun 20 is electrically connected to the electrical apparatus.

In a state where the electrical apparatus needs to be charged, the charging gun 20 can be separated from the cabinet body 10 so as to be electrically connected to the electrical apparatus; and in a state where charging is not required, the charging gun 20 can be directly placed on the cabinet body 10.

It can be understood that the charging gun 20 is placed on the outer surface of the cabinet body 10 to facilitate the separation operation.

The cable 30 is used to supply electric energy stored in the energy storage component 60 to the charging gun 20.

A portion of the cable 30 is positioned outside the cabinet body 10, so that during use of the charging gun 20 by an operator, the movement range of the charging gun 20 can be expanded to adapt to different positions of the electrical apparatus.

A portion of the cable 30 outside the cabinet body 10 passing through the air inlets 10c means that a portion of the cable 30 passes through an opening in the air inlets 10c so that the airflow entering through the air inlets 10c can be in contact with the cable 30 and then exchange heat with the cable 30.

It can be understood that the devices in the cabinet body 10, such as the energy storage component 60, will generate heat during operation, and the airflow entering the cabinet body 10 can absorb some heat and carry the heat out of the cabinet body 10. Therefore, the temperature of the airflow discharged from the cabinet body 10 is higher than the temperature of the airflow entering the cabinet body 10.

According to the energy storage apparatus in the embodiments of the present disclosure, at least a portion of the cable 30 passes through the air inlets 10c so that the cable 30 can directly dissipate heat and cool through the airflow entering through the air inlets 10c, thereby reducing the adverse effect of high temperature of the cable 30 on the charging efficiency of the charging gun 20. The airflow for heat exchange with the cable 30 is the normal temperature airflow from the outside, which helps increase the temperature difference between the airflow and the cable 30, improve the efficiency of heat exchange, and improve the cooling effect on the cable 30. The air vents 10a are formed on the surface of the cabinet body 10, which helps reduce the overall outer contour size of the energy storage apparatus and improve the mounting adaptability of the energy storage apparatus.

The number of the air vents 10a is not limited, and one or more air vents 10a may be arranged.

In some embodiments, referring to FIG. 2 and FIG. 3, the air vents 10a further include air outlets 10d, and the air outlets 10d are used to discharge the airflow in the cabinet body 10 out of the cabinet body 10. The air inlets 10c are arranged on a first wall 10e of the cabinet body 10, and the air outlets 10d are arranged on a second wall 10f of the cabinet body 10.

The air inlets 10c and the air outlets 10d are positioned on different walls.

Thus, the air discharged from the air outlets 10d is not likely to re-enter through the air inlets 10c without completely cooling, which helps reduce the probability of temperature rise of the airflow entering through the air inlets 10c, increase the temperature difference between the airflow and the cable 30, improve the efficiency of heat exchange, and improve the cooling effect on the cable 30.

It can be understood that the cable 30 needs to be kept away from the air outlets 10d to reduce the probability that the cable 30 is heated by the airflow with a higher temperature.

In some embodiments, referring to FIG. 2 and FIG. 3, the first wall 10e is positioned on one side of the cabinet body 10 along the first direction, and the second wall 10f is positioned on one side of the cabinet body 10 along the second direction. The first direction intersects the second direction, and both are perpendicular to the vertical direction.

The vertical direction refers to a rectilinear direction of gravity.

Thus, the direction of the air inlets 10c is different from that of the air outlets 10d, and the air inlets 10c are far away from the air outlets 10d, thereby reducing the probability that the airflow discharged through the air outlets 10d blows onto the cable 30.

It can be understood that the first wall 10e extends in the vertical direction, so as to limit the cable 30 and reduce the probability that the cable 30 shakes due to hanging and moves away from the air vents 10a.

In some embodiments, referring to FIG. 2, a placing area 10g for placing the charging gun 20 is arranged on the outer surface of the cabinet body 10, and the cable outlet 10b, the placing area 10g and the air outlets 10c are all positioned on the first wall 10e.

The placing area 10g refers to an area where the charging gun 20 is in contact with the cabinet body 10 in a state where the charging gun 20 is not separated from the cabinet body 10.

Thus, the probability that the cable 30 passes by the second wall 10f is reduced during use of the charging gun 20, which helps reduce the probability that the airflow discharged from the air outlets 10d blows onto the cable 30.

The specific form of forming the placing area 10g is not limited. For example, a bracket is arranged on the surface of the cabinet body 10, and the charging gun 20 can be mounted on the bracket. For another example, a fixing hole is formed on the surface of the cabinet body 10, and the charging gun 20 is inserted into the fixing hole for fixation.

In some embodiments, referring to FIG. 1 to FIG. 3, the cabinet body 10 includes a third wall 10h, the third wall 10h is positioned on a side of the cabinet body 10 opposite to the second wall 10f along the second direction, and the third wall 10h is used to face the electrical apparatus.

Thus, the probability that the cable 30 passes by the second wall 10f is reduced during use of the charging gun 20, which helps reduce the probability that the airflow discharged from the air outlets 10d blows onto the cable 30.

In some embodiments, the first direction is perpendicular to the second direction.

It can be understood that the cable 30 is a flexible structure. Under the action of gravity and the pulling force generated by each use of the charging gun 20, the cable 30 itself will bend, coil, and deform, causing the outer contour and position of the cable 30 to change relative to the cabinet body 10.

It can be understood that the position of the cable outlet 10b on the surface of the cabinet body 10 is fixed and unchanged. No matter how the position and shape of the cable 30 change, a portion of the cable 30 always passes through the cable outlet 10b and is positioned near the cable outlet 10b.

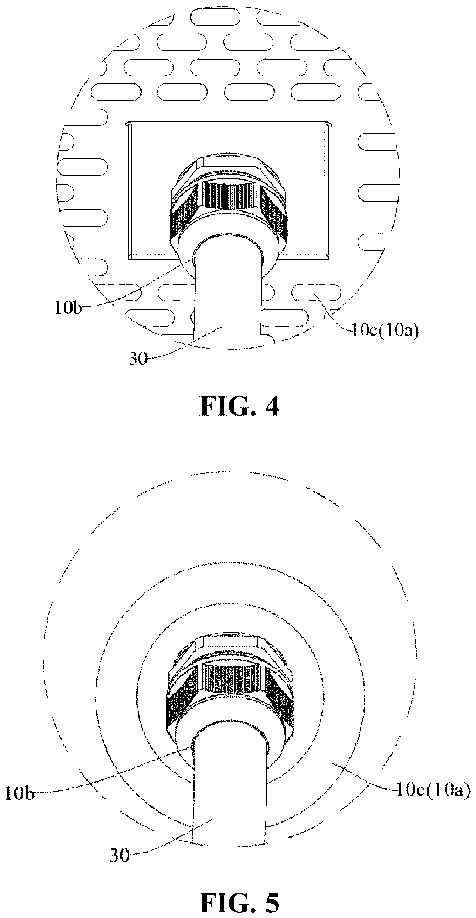

In some embodiments, referring to FIG. 5, the air vents 10a and the cable outlet 10b are positioned on the same wall of the cabinet body 10, and at least one air vent 10a is arranged around the cable outlet 10b.

The wall refers to each surface forming the outer contour surface of the cabinet body 10. It can be understood that the cabinet body 10 includes a plurality of walls.

That is, in a projection plane perpendicular to the normal of the wall where the air vent 10a and the cable outlet 10b are positioned, the projection of the cable outlet 10b along the normal direction is positioned inside the projection of the air vent 10a along the normal direction. No matter to what angle the cable 30 is rotated or bent, the cable 30 needs to pass through the air vent 10a.

Thus, the portion of the cable 30 positioned near the cable outlet 10b can always exchange heat with the airflow entering and exiting through the air vents 10a, thereby improving the heat dissipation effect on the cable 30.

In some embodiments, referring to FIG. 4, the air vents 10a and the cable outlet 10b are positioned on the same wall of the cabinet body 10, and a plurality of air vents 10a are arranged at intervals on the circumferential side of the cable outlet 10b.

That is, in a projection plane perpendicular to the normal of the wall where the air vents 10a and the cable outlet 10b are positioned, the projection of the cable outlet 10b along the normal direction is positioned inside an area enclosed by the projections of the plurality of air vents 10a along the normal direction.

Thus, the portion of the cable 30 positioned near the cable outlet 10b can always exchange heat with the airflow entering and exiting through the air vents 10a, thereby improving the heat dissipation effect on the cable 30. Also, the air vents 10a are arranged in a grid shape, which helps reduce the adverse effect on the structural strength of the cabinet body 10 due to the formation of the air vents 10a, and also reduce the probability of entrance of foreign matter through the air vents 10a.

In some embodiments, referring to FIG. 2, FIG. 3, and FIG. 6 to FIG. 10, the energy storage apparatus further includes a limiting member 40. The limiting member 40 is arranged on the outer surface of the cabinet body 10, the limiting member 40 is provided with a support surface 40b, and the support surface 40b supports the cable 30 in a vertical direction. In a state where the charging gun 20 is placed on the cabinet body 10, the support surface 40b is not lower than at least one of the connection position between the charging gun 20 and the cable 30 and the cable outlet 10b in the vertical direction.

That is, in the vertical direction, the distance between the support surface 40b and the bottom of the cabinet body 10 is L1, the distance between the upper edge of the connection position between the charging gun 20 and the cable 30 and the bottom of the cabinet body 10 is L2, and the distance between the upper edge of the cable outlet 10b and the bottom of the cabinet body 10 is L3. The value of either L2 or L3 is smaller than the value of L1.

Thus, the cable 30 is supported by the support surface 40b, which helps increase the length of the portion of the cable 30 outside the cabinet body 10. Also, since the limiting member 40 can limit the cable 30 through friction, the portion of the cable 30 between the support surface 40b and the cable outlet 10b can maintain stable in position when the charging gun 20 is moved, which helps maintain heat exchange between the airflow at the air vents 10a and the portion of the cable 30, and improve the cooling efficiency.

It can be understood that the position of the support surface 40b relative to the surface of the cabinet body 10 is fixed and unchanged. No matter how the position and shape of the cable 30 change, a portion of the cable 30 is always positioned on the support surface 40b and near the limiting member 40.

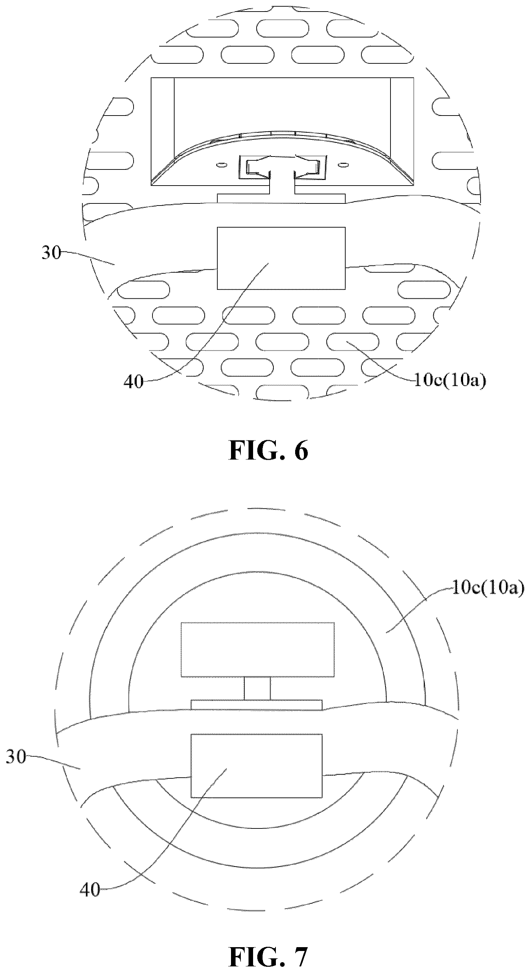

In some embodiments, referring to FIG. 7, the air vents 10a and the limiting member 40 are positioned on the same wall of the cabinet body 10, and at least one air vent 10a is arranged around the limiting member 40.

That is, in a projection plane perpendicular to the normal of the wall where the air vent 10a and the limiting member 40 are positioned, the projection of the limiting member 40 along the normal direction is positioned inside the projection of the air vent 10a along the normal direction. No matter to what angle the cable 30 is rotated or bent, the cable 30 needs to pass through the air vent 10a.

Thus, the portion of the cable 30 positioned near the limiting member 40 can always exchange heat with the airflow entering and exiting through the air vents 10a, thereby improving the heat dissipation effect on the cable 30.

In some embodiments, referring to FIG. 6, the air vents 10a and the limiting member 40 are positioned on the same wall of the cabinet body 10, and a plurality of air vents 10a are arranged at intervals on the circumferential side of the limiting member 40.

That is, in a projection plane perpendicular to the normal of the wall where the air vents 10a and the limiting member 40 are positioned, the projection of the limiting member 40 along the normal direction is positioned inside an area enclosed by the projections of the plurality of air vents 10a along the normal direction.

Thus, the portion of the cable 30 positioned near the limiting member 40 can always exchange heat with the airflow entering and exiting through the air vents 10a, thereby improving the heat dissipation effect on the cable 30.

In some embodiments in which the placing area 10g, the air inlets 10c and the air outlets 10d are arranged, referring to FIG. 2, the limiting member 40, the cable outlet 10b, the placing area 10g and the air inlets 10c are all positioned on the first wall 10e of the cabinet body 10, and the air outlets 10d are positioned on the second wall 10f of the cabinet body 10.

Thus, the probability that the cable 30 passes by the second wall 10f is reduced during use of the charging gun 20, which helps reduce the probability that the airflow discharged from the air outlets 10d blows onto the cable 30.

The cable 30 can be divided into two portions, namely, a first portion from one end connected to the charging gun 20 to the limiting member 40, and a second portion from the limiting member 40 to a cable through hole 40a. During the process of taking or placing the charging gun 20, the first portion will move. If the first portion comes into contact with the second portion, the second portion may be driven to move.

In some embodiments, referring to FIG. 2, on a projection plane perpendicular to the vertical direction, the projection of the limiting member 40 along the vertical direction is between the projection of the cable outlet 10b along the vertical direction and the projection of the placing area 10g along the vertical direction.

Thus, the probability that the portion of the cable 30 from the end connected to the charging gun 20 to the limiting member 40 is in overlapping contact with the portion of the cable 30 from the limiting member 40 to a cable through hole 40a under the action of gravity is reduced, which helps make the two portions hang naturally under gravity, reduce the probability that the portion of the cable 30 from the limiting member 40 to the cable through hole 40a moves away from the air vents 10a, and improve the heat dissipation effect.

It can be understood that in the process of taking or placing the charging gun 20 by an operator, the charging gun 20 moves with an operator's hand.

In some embodiments, referring to FIG. 3, in the vertical direction, the distance between the support surface 40b and the bottom surface of the cabinet body 10 is 2 m (meter) or more, i.e., L1≥2 m.

During the process of taking or placing the charging gun 20 by an operator, the height of the support surface 40b can always be higher than the height of the charging gun 20.

Thus, the probability that the cable 30 on the support surface 40b moves or even falls off the support surface 40b due to the movement of the charging gun 20 is reduced, and also the portion of the cable 30 from the limiting member 40 to the cable through hole 40a is maintained stable in position and passing through the air vents 10a.

The specific value of the distance between the support surface 40b and the bottom surface of the cabinet body 10 may be 2 m, 2.1 m, 2.2 m, 2.3 m, 2.4 m, or the like.

The specific method of forming the support surface 40b is not limited.

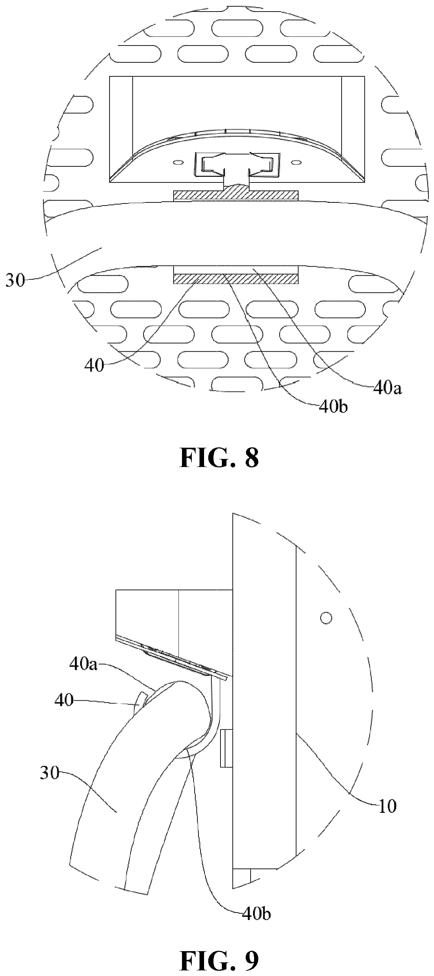

Exemplarily, referring to FIG. 8, FIG. 9 and FIG. 10, a cable through hole 40a is formed in the limiting member 40, the cable 30 passes through the cable through hole 40a, and the bottom wall of the cable through hole 40a forms the support surface 40b.

Thus, on the one hand, the inside of the cable through hole 40a can support the cable 30, and on the other hand, the side wall of the cable through hole 40a can restrain the cable 30 in a direction perpendicular to the vertical direction, which further helps restrain the movement range of the cable 30 and reduce the probability that the cable 30 escapes from the influence range of the airflow at the air vents 10a.

The specific structural form of the limiting member 40 is not limited.

For example, referring to FIG. 7 and FIG. 9, the limiting member 40 is a hook, and the top side of the cable through hole 40a is open to allow the cable 30 to enter and exit, thereby facilitating the disassembly, assembly, and replacement of the cable 30.

For another example, referring to FIG. 8 and FIG. 9, the limiting member 40 is a hold hoop to improve the restraining effect of the limiting member 40, which further helps restrain the movement range of the cable 30 and reduce the probability that the cable 30 escapes from the influence range of the airflow at the air vents 10a.

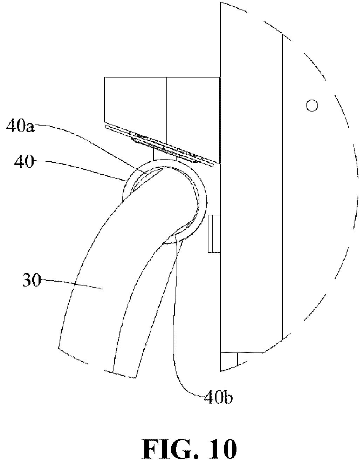

In some embodiments, referring to FIG. 9 and FIG. 10, the cross-sectional area of the cable through hole 40a perpendicular to the extension direction thereof is larger than the cross-sectional area of the cable 30 perpendicular to the extension direction thereof.

The cable 30 can pass through the cable through hole 40a along the extension direction of the cable through hole 40a.

Thus, the length of the cable from the charging gun 20 to the limiting member 40 can be flexibly adjusted according to the charging position requirement of an electrical apparatus for the charging gun 20, and the flexibility in use is improved.

The specific method of forming the inlet and outlet airflows at the air vents 10a is not limited.

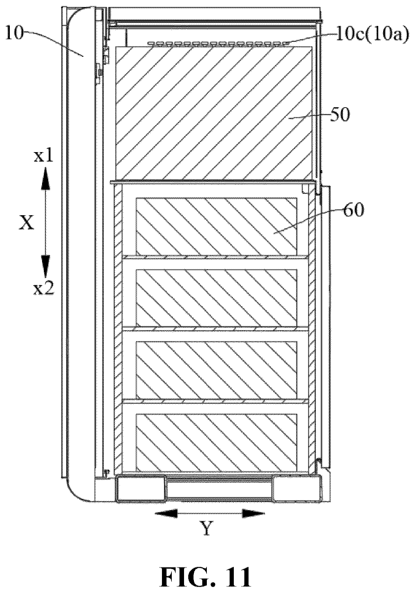

In some embodiments, referring to FIG. 11, the energy storage apparatus further includes a heat dissipation device 50, and the heat dissipation device 50 is arranged in the cabinet body 10 and is used to dissipate heat from the energy storage component 60 and drive airflow in and out through the air vents 10a.

Thus, the airflow formed by the heat dissipation device 50 is directly used to dissipate heat from the cable 30, which helps simplify the structure of the energy storage apparatus and reduce the power consumption of the energy storage apparatus.

The specific method by which the heat dissipation device 50 achieves heat dissipation is not limited. For example, the heat dissipation device 50 includes a delivery pump, a heat exchange circuit and a fan. The heat exchange circuit stores a fluid medium, e.g., water, for heat exchange. The delivery pump is used to drive the fluid medium to circulate during heat exchange. The fluid medium in a heat absorption part of the heat exchange circuit exchanges heat with the energy storage component 60. After absorbing heat from the energy storage component 60, the fluid medium flows to a heat release part of the heat exchange circuit. The fan rotates and draws airflow from the outside of the cabinet body 10. The airflow heats up by exchanging heat with the fluid medium in the heat release part and then is driven to exit the cabinet body 10 by the fan. The cooled fluid medium flows back to the heat absorption part. The above process is repeated to achieve the purpose of cooling the energy storage component 60 and generating airflow.

In some embodiments, referring to FIG. 11, the heat dissipation device 50 is positioned above the energy storage component 60, and the air vents 10a are positioned on at least one side of the heat dissipation device 50 perpendicular to the vertical direction.

It can be understood that the mass of the heat dissipation device 50 is smaller than that of the energy storage component 60.

The air vents 10a and the heat dissipation device 50 are both higher than the energy storage component 60.

Thus, the height of center of gravity of the energy storage apparatus is lowered and the risk of the energy storage apparatus overturning is reduced. The projections of the heat dissipation device 50 and the energy storage component 60 in the vertical direction at least partially overlap, and the footprint of the energy storage apparatus is reduced. The length of the airflow path from the air vents 10 to the heat dissipation device 50 is reduced and the airflow efficiency is improved. The position of the air vents 10 is relatively high, which helps reduce the probability that the airflow at the air vents blows onto an operator during the charging operation on the energy storage apparatus.

It can be understood that in some embodiments including the air inlets 10c and the air outlets 10d, referring to FIG. 11, the air inlets 10c are positioned on at least one side of the heat dissipation device 50 along the first direction, and the air outlets 10d are positioned on at least one side of the heat dissipation device 50 along the second direction. The first direction is perpendicular to the second direction, and both are perpendicular to the vertical direction.

In an embodiment in which the energy storage component 60 is a battery, the battery includes a box body and at least one battery cell.

The box body includes a top cover and a bottom cover, and the top cover is covered above the bottom cover, so that a mounting space for placing the battery cell is enclosed between the bottom cover and the top cover.

In the battery, one or more battery cells may be arranged, and the plurality of battery cells may be in series, or parallel, or series-parallel connection. The series-parallel connection means that the plurality of battery cells are connected both in series and in parallel. The plurality of battery cells may be in direct series, or parallel, or series-parallel connection, and then the whole formed by the plurality of battery cells is placed in the accommodating space formed by the bottom cover and the top cover. Of course, the battery may also include a plurality of battery cells which are in series, or parallel, or series-parallel connection to form battery modules, and then a plurality of battery modules are in series, or parallel, or series-parallel connection to form a whole to be placed in the accommodating space formed by the bottom cover and the top cover. The battery may further include other structures. For example, the battery may further include a busbar component for achieving electrical connection between the plurality of battery cells.

The battery cell mentioned in the embodiments of the present disclosure includes an electrode assembly and an electrolytic solution, and the electrode assembly includes a positive electrode plate, a negative electrode plate and a separator. The operation of the battery cell mainly relies on the movement of metal ions between the positive electrode plate and the negative electrode plate. The positive electrode plate includes a positive electrode current collector and a positive electrode active material layer. A surface of the positive electrode current collector is coated with the positive electrode active material layer. A current collector not coated with the positive electrode active material layer protrudes from a current collector coated with the positive electrode active material layer. The current collector not coated with the positive electrode active material layer is stacked to serve as a positive tab. Taking a lithium-ion battery as an example, the material of the positive electrode current collector may be aluminum, and the positive electrode active material may be lithium cobalt oxide, lithium iron phosphate, ternary lithium, lithium manganate, or the like. The negative electrode plate includes a negative electrode current collector and a negative electrode active material layer. A surface of the negative electrode current collector is coated with the negative electrode active material layer. A current collector not coated with the negative electrode active material layer protrudes from a current collector coated with the negative electrode active material layer. The current collector not coated with the negative electrode active material layer is stacked to serve as a negative tab. The material of the negative electrode current collector may be copper, and the negative electrode active material may be carbon, silicon, or the like. The material of the separator may be polypropylene (PP), polyethylene (PE), or the like. In addition, the electrode assembly may be of a wound structure or a stacked structure.

The battery cell may be a secondary battery, and the secondary battery refers to a battery cell that can be used continually by activating an active material by charging after the battery cell is discharged.

The battery cell may be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, a lead storage battery, or the like, which is not limited in the embodiment of the present disclosure.

The battery cell may be a cylindrical battery cell, a prismatic battery cell, a pouch cell, or a battery cell of other shapes. The prismatic battery cell may be a square battery cell, a blade battery cell, or a polygon prismatic battery. For example, the polygon prismatic battery may be a hexagonal prismatic battery or the like, which is not specifically limited in the embodiments of the present disclosure.

The battery mentioned in the embodiments of the present disclosure refers to a single physical module including one or more battery cells to provide a higher voltage and capacity.

A specific embodiment of the present disclosure is as follows:
An energy storage apparatus includes a cabinet body 10, a charging gun, a cable 30, a limiting member 40, a heat dissipation device 50, and an energy storage component 60. Air outlets 10d, air inlets 10c and a cable outlet 10b are arranged on an outer surface of the cabinet body 10. A portion of the cable 30 is positioned outside the cabinet body 10, one end of the cable 20 is electrically connected to the charging gun 20, the other end enters the cabinet body 10 through the cable outlet 10b and is electrically connected to the energy storage component 60, and at least a portion of the cable 30 passes through the air inlets 10c. A placing area 10g for placing the charging gun 20 is arranged on the outer surface of the cabinet body 10. The limiting member 40 is arranged on the outer surface of the cabinet body 10, the limiting member 40 is provided with a support surface 40b, and the support surface 40b supports the cable 30 in a vertical direction. In a state where the charging gun 20 is placed on the cabinet body 10, the support surface 40b is not lower than at least one of the connection position between the charging gun 20 and the cable 30 and the cable outlet 10b in the vertical direction. The limiting member 40, the cable outlet 10b, the placing area 10g and the air inlets 10c are all positioned on a first wall 10e of the cabinet body 10, and the air outlets 10d are positioned on a second wall 10f of the cabinet body 10. A plurality of air inlets 10c are arranged at intervals on the circumferential side of the cable outlet 10b. A plurality of air inlets 10c are arranged at intervals on the circumferential side of the limiting member 40. On a projection plane perpendicular to the vertical direction, the projection of the limiting member 40 along the vertical direction is between the projection of the cable outlet 10b along the vertical direction and the projection of the placing area 10g along the vertical direction. In the vertical direction, the distance between the support surface 40b and the bottom surface of the cabinet body 10 is 2 m or more. A cable through hole 40a is formed in the limiting member 40, the cable 30 passes through the cable through hole 40a, and the bottom wall of the cable through hole 40a forms the support surface 40b. The cross-sectional area of the cable through hole 40a perpendicular to the extension direction thereof is larger than the cross-sectional area of the cable 30 perpendicular to the extension direction thereof. The heat dissipation device 50 and the energy storage component 60 are arranged in the cabinet body 10, and the heat dissipation device 50 is used to dissipate heat from the energy storage component 60 and drive airflow in and out through the air vents 10d. The heat dissipation device 50 is positioned above the energy storage component 60, and the air vents 10a are positioned on at least one side of the heat dissipation device 50 perpendicular to the vertical direction.

The embodiments provided in the present disclosure may be combined with each other without contradiction.

The above are merely exemplary embodiments of the present disclosure and are not intended to limit the embodiments of the present disclosure. For those skilled in the art, the embodiments of the present disclosure may have various modifications and variations. Any modifications, equivalent replacements and improvements made within the spirit and principle of the embodiments of the present disclosure shall be included in the scope of protection of the embodiments of the present disclosure.

## Claims

1. An energy storage apparatus, comprising:
a cabinet body, wherein air vents and a cable outlet are arranged on an outer surface of the cabinet body, the air vents comprise air inlets, and the air inlets are used for airflow entering the cabinet body;
an energy storage component, being arranged in the cabinet body;
a charging gun, being configured to be separable from the outer surface of the cabinet body; and
a cable, a portion of the cable being positioned outside the cabinet body, one end of the cable being electrically connected to the charging gun, the other end entering the cabinet body through the cable outlet and being electrically connected to the energy storage component, and at least a portion of the cable passing through the air inlets.

2. The energy storage apparatus according to claim **1,** wherein the air vents further comprise air outlets, the air outlets are used to discharge the airflow in the cabinet body out of the cabinet body, the air inlets are arranged on a first wall of the cabinet body, and the air outlets are arranged on a second wall of the cabinet body.

3. The energy storage apparatus according to claim 2, wherein a placing area for placing the charging gun is arranged on the outer surface of the cabinet body, and the cable outlet, the placing area and the air inlets are all positioned on the first wall.

4. The energy storage apparatus according to any one of claims 1-3, wherein the air vents and the cable outlet are positioned on the same wall of the cabinet body, and at least one air vent is arranged around the cable outlet;
or, a plurality of air vents are arranged at intervals on the circumferential side of the cable outlet.

5. The energy storage apparatus according to any one of claims 1-4, wherein the energy storage apparatus further comprises a limiting member, the limiting member is arranged on the outer surface of the cabinet body, the limiting member is provided with a support surface, the support surface supports the cable in a vertical direction, and in a state where the charging gun is placed on the cabinet body, the support surface is not lower than at least one of the connection position between the charging gun and the cable and the cable outlet in the vertical direction.

6. The energy storage apparatus according to claim 5, wherein the air vents and the limiting member are positioned on the same wall of the cabinet body, and at least one air vent is arranged around the limiting member;
or, a plurality of air vents are arranged at intervals on the circumferential side of the limiting member.

7. The energy storage apparatus according to claim 5 or 6, wherein a placing area for placing the charging gun is arranged on the outer surface of the cabinet body, the air vents comprise air inlets and air outlets, the limiting member, the cable outlet, the placing area and the air inlets are all positioned on the first wall of the cabinet body, and the air outlets are positioned on the second wall of the cabinet body.

8. The energy storage apparatus according to claim 7, wherein on a projection plane perpendicular to the vertical direction, the projection of the limiting member along the vertical direction is between the projection of the cable outlet along the vertical direction and the projection of the placing area along the vertical direction.

9. The energy storage apparatus according to any one of claims 5-8, wherein in the vertical direction, the distance between the support surface and the bottom surface of the cabinet body is 2 m or more.

10. The energy storage apparatus according to any one of claims 5-9, wherein a cable through hole is formed in the limiting member, the cable passes through the cable through hole, and the bottom wall of the cable through hole forms the support surface.

11. The energy storage apparatus according to claim 10, wherein the cross-sectional area of the cable through hole perpendicular to the extension direction thereof is larger than the cross-sectional area of the cable perpendicular to the extension direction thereof.

12. The energy storage apparatus according to any one of claims 1-11, wherein the energy storage apparatus further comprises a heat dissipation device, and the heat dissipation device is arranged in the cabinet body and is used to dissipate heat from the energy storage component and drive airflow in and out through the air vents.

13. The energy storage apparatus according to claim 12, wherein the heat dissipation device is positioned above the energy storage component, and the air vents are positioned on at least one side of the heat dissipation device perpendicular to the vertical direction.
